Europäisches Patentamt

**European Patent Office**

Office européen des brevets

(11) Veröffentlichungsnummer: **0 265 833 B1**

## EUROPÄISCHE PATENTSCHRIFT

(45) Veröffentlichungstag der Patentschrift: **24.07.91**

(51) Int. Cl.5: **H01L 23/58**, H01L 25/04

(21) Anmeldenummer: **87115443.1**

(22) Anmeldetag: **21.10.87**

(54) Halbleiterbauelement mit mindestens einem Leistungs-MOSFET.

(30) Priorität: **22.10.86 DE 3635956**

(43) Veröffentlichungstag der Anmeldung:
**04.05.88 Patentblatt 88/18**

(45) Bekanntmachung des Hinweises auf die
Patenterteilung:
**24.07.91 Patentblatt 91/30**

(84) Benannte Vertragsstaaten:
**DE FR GB IT SE**

(56) Entgegenhaltungen:
**EP-A- 0 018 091**
**EP-A- 0 030 168**
**DE-A- 3 043 903**
**DE-C- 3 327 186**

**PATENT ABSTRACTS OF JAPAN, Band 8, Nr.
123 (E-249)[1560], 8. Juni 1984 & JP-A-59-35
456**

**PATENT ABSTRACTS OF JAPAN, Band 5, Nr.
176 (E-81)[848], 12. November 1981 & JP-
A-56-103 457**

(73) Patentinhaber: **Siemens Aktiengesellschaft
Wittelsbacherplatz 2
W-8000 München 2(DE)**

Patentinhaber: **Semikron Elektronik GmbH
Postfach 82 02 51
W-8500 Nürnberg 82(DE)**

(72) Erfinder: **Hebenstreit, Ernst, Dipl.-Ing.
Am Blütenanger 14
W-8000 München 50(DE)**
Erfinder: **Schierz, Winfried
Heidestrasse 2
W-8548 Heideck(DE)**
Erfinder: **Lorenz, Leo, Dr.
Max-Loew-Strasse 14
W-8014 Neubiberg(DE)**
Erfinder: **Amann, Heinz
Fasanenstrasse 100
W-8025 Unterhaching(DE)**

(74) Vertreter: **Fuchs, Franz-Josef, Dr.-Ing.
Postfach 22 13 17
W-8000 München 22(DE)**

## Beschreibung

Die Erfindung bezieht sich auf ein Halbleiterbauelement mit mindestens einem Leistungs-MOSFET, dessen Halbleiterkörper einen Sourcekontakt und einen mit diesem verbundenen Sourceanschluß sowie einen Gatekontakt und einen mit diesen verbundenen Gateanschluß hat.

Solche Halbleiterbauelemente werden durch eine zwischen den Sourcekontakt und den Gatekontakt angelegte Steuerspannung leitend gesteuert. Die Steuerspannung wird in der Praxis zwischen den Sourceanschluß und den Gateanschluß gelegt. Der als Sourceanschluß dienende Draht hat eine Eigeninduktivität, die bewirkt, daß der sich beim Einschalten oder Ausschalten des MOSFET zeitlich ändernde Laststrom eine Spannung in der Induktivität induziert, die der Steuerspannung schaltverzögernd entgegenwirkt. Schaltet man mehrere Leistungs-MOSFET parallel und steuert sie gemeinsam aus einer einzigen Spannungsqeulle an, so führt die erwähnte Induktivität dazu, daß im Ansteuerkreis wegen unvermeidlicher Bauelementetoleranzen hochfrequente Schwingungen mit Amplituden auftreten, die den FET-Eingang zerstören können. Die Schwingfrequenz wird maßgeblich durch die erwähnte Induktivität des Sourceanschlusses und daneben durch andere parasitäre Netzwerk- und Bauelementeparameter bestimmt. Die Amplitude der Schwingung wird durch die große Steilheit des MOSFET verstärkt.

Die Schwingungen beim Einschalten von parallelgeschalteten Leistungs-MOSFET wurden beispielsweise in den Veröffentlichungen "PCI Oktober 1984 Proceedings" Seiten 209 bis 213 und "MOTOROLA TMOS POWER MOSFET DATA", Seiten A-49 bis A-70 beschrieben. Zur Verhinderung der hochfrequenten Schwingungen wird dort vorgeschlagen, in die Gateanschlüsse der parallel geschalteten MOSFET jeweils einen Widerstand oder eine Ferritperle einzuschalten. Versuche haben jedoch ergeben, daß sich die geschilderten Probleme damit zwar mindern, jedoch nicht völlig beseitigen lassen, wenn schnell geschaltet werden soll.

Der Erfindung liegt die Aufgabe zugrunde, ein Halbleiterbauelement der erwähnten Art derart weiterzubilden, daß die erwähnte nachteilige Wirkung der Induktivität des Sourceanschlusses weiter vermindert wird und die erwähnten Schwingungen bei parallel geschalteten MOSFET auch bei schnellem Schalten in der Größenordnung unterhalb einer Microsekunde vermieden werden.

Diese Aufgabe wird gelöst durch ein elektrisch isolierendes, thermisch leitendes, mit Leiterbahnen versehenes Substrat, durch mehrere, auf einer ersten Leiterbahn in einer Reihe hintereinander angeordnete Halbleiterkörper, durch eine zweite, auf der einen Längsseite der Reihe liegende Leiterbahn, die elektrisch mit den Sourcekontakten verbunden ist, durch eine dritte, auf der anderen Längsseite der Reihe liegende Leiterbahn, die mit den Gatekontakten verbunden ist, und durch eine vierte, ebenfalls auf der anderen Längsseite der Reihe liegende Leiterbahn, die einen Hilfsanschluß bildet und mit den Sourcekontakten verbunden ist.

Weiterbildungen der Erfindung sind Gegenstand der Unteransprüche.

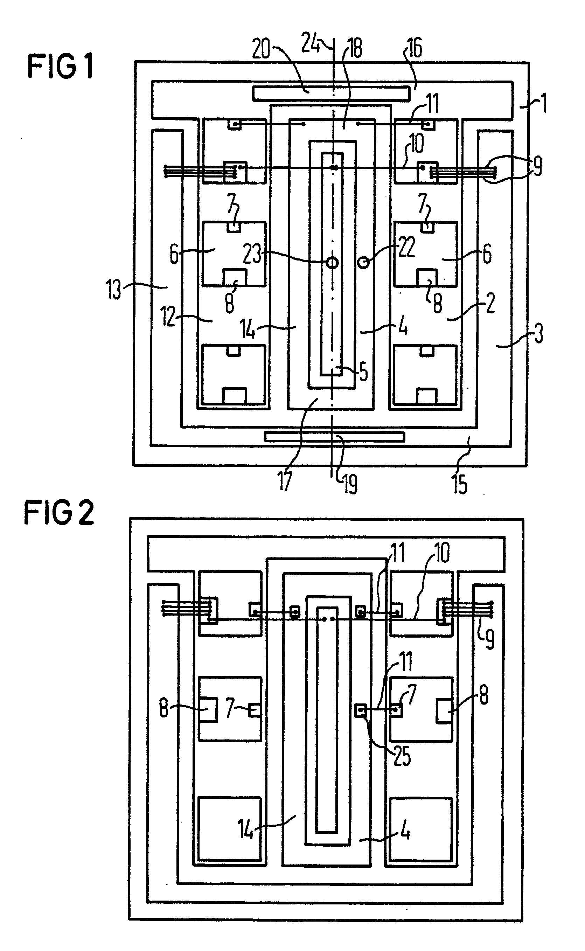

Die Erfindung wird anhand von Ausführungsbeispielen in Verbindung mit den Figuren 1 bis 3 näher erläutert. Diese zeigen Aufsichten auf drei Ausführungsbeispiele mit jeweils parallel geschalteten MOSFET-Halbleiterkörpern.

Das Halbleiterbauelement nach Figur 1 ist auf einem isolierenden, wärmeleitenden Substrat 1 aufgebaut. Das Substrat kann beispielsweise aus einer bekannten Aluminiumoxidkeramik bestehen. Es ist mit ersten Leiterbahnen 2, 12, zweiten Leiterbahnen 3, 13 und dritten Leiterbahnen 4, 14 versehen. Diese Leiterbahnen liegen einander parallel und sind spiegelsymmetrisch zu einer eine Längsachse des Substrats 1 bildenden Symmetrieachse 24 angeordnet. Das Substrat ist außerdem mit einer vierten Leiterbahn 5 versehen, die auf der Symmetrieachse 24 sitzt.

Die ersten Leiterbahnen 2, 12 und die zweiten Leiterbahnen 3, 13 sind durch Brücken 15 bzw. 16 leitend miteinander erbunden. Die dritten Leiterbahnen 4, 14 sind durch Brücken 17, 18 elektrisch miteinander verbunden. Die Leiterbahnen 2, 12 bilden zusammen mit der Brücke 16 einen ersten U-förmigen Leiter, während die Leiterbahnen 3, 13 mit der Brücke 15 einen zweiten U-förmigen Leiter bilden. Beide U-förmigen Leiter sind gegeneinander um 180° verdreht und ineinander verschachtelt auf dem Substrat angeordnet.

Auf den ersten Leiterbahnen 2, 12 sind in zwei Reihen hintereinander Halbleiterkörper 6 angeordnet, die jeweils einen Leistungs-MOSFET bilden. Die Halbleiterkörper 6 sind jeweils mit einem Gatekontakt 7 und einem Sourcekontakt 8 versehen. Die Sourcekontakte 8 sind z. B. über Bonddrähte 9 mit den zweiten Leiterbahnen 3, 13 verbunden. Die Leiterbahnen 3, 13 bilden zusammen mit der Brücke 15 und den Bonddrähten 9 den Sourceanschluß. Die Gatekontakte 7 sind jeweils über einen oder mehrere Bonddrähte 11 mit den dritten Leiterbahnen 4, 14 verbunden. Diese Leiterbahnen bilden zusammen mit den Brücken 17, 18 und den Bonddrähten 11 den Gateanschluß des Halbleiterbauelements. Die Leiterbahnen 2, 12 dienen als Drainanschluß.

Zusätzlich sind die Sourcekontakte 8 über Bonddrähte 10 mit der Leiterbahn 5 verbunden. Die Bonddrähte 10 bilden zusammen mit der Leiterbahn 5 einen Hilfsanschluß zur Ansteuerung der parallel geschalteten MOSFET. Um die Bonddrähte kurz zu halten, liegen sie rechtwinklig zu den Leiterbahnen.

Das Halbleiterbauelement wird durch eine zwischen Gateanschluß und Hilfsanschluß angelegte Steuerspannung eingeschaltet. Dadurch, daß die Leiterbahnen 3, 13 d. h. die Sourceanschlüsse auf der einen Seite der Reihe von Halbleiterkörpern, im Ausführungsbeispiel auf der Außenseite des Substrats und die Leiterbahnen für die Ansteuerung der Halbleiterkörper auf der anderen Seite der Reihe von Halbleiterkörpern angeordnet sind, ergibt sich eine weitgehende magnetische Entkopplung des Ansteuerkreises von den Sourceanschlüssen des Halbleiterbauelements. Ein solches Halbleiterbauelement läßt sich z. B. innerhalb von 100 ns vollständig durchschalten, ohne daß es im Ansteuerkreis zu hochfrequenten Schwingungen kommt. Die magnetische Entkopplung ist bei gegebener Lage der Leiterbahnen um so besser, je weiter die den Laststrom führenden Bonddrähte 9 vom Bonddraht 10 entfernt sind. Optimal ist die Anordnung dann, wenn, wie dargestellt, die Bonddrähte 9 und 10 nach entgegengesetzten Seiten vom Sourcekontakt 8 abstehen.

Eine weitere Verbesserung des Ansteuerverhaltens läßt sich dadurch erreichen, daß die zum Steuerkreis gehörenden Leitersysteme, bestehend aus den Bonddrähten 10, 11 und im wesentlichen den Leiterbahnen 4, bzw. 14 nahe beieinander angeordnet sind und mindestens teilweise einander parallel liegen. Damit läßt sich die Induktivität des Steuerkreises verringern. Die erwähnten Bonddrähte und Leiterbahnen können so nahe beieinander angeordnet sein, wie dies aus Isolations-und Fertigungsgründen möglich ist.

In Figur 1 sind die Halbleiterkörper 6 derart auf den Leiterbahnen 2, 12 angeordnet, daß die Bonddrähte 10 und 11 relativ weit auseinander liegen. Im Ausführungsbeispiel nach Figur 2 sind die Halbleiterkörper gegenüber dem Ausführungsbeispiel nach Figur 1 um 90 Grad gedreht. Damit wird eine räumlich benachbarte Anordnung der zum Steuerkreis gehörenden Bonddrähte 10 und 11 möglich, wenn die Source- und Gatekontakte einander am Rand der Halbleiterkörper gegenüberliegen.

Die Drainanschlüsse, Sourceanschlüsse und Gateanschlüsse sowie die Hilfsanschlüsse sind mit Gehäuseanschlüssen 19, 20, 22 und 23 verbunden. Dabei bildet 19 den Source-Gehäuseanschluß, 20 den Drain-Gehäuseanschluß, 22 den Gate-Gehäuseanschluß und 23 den Hilfs-Gehäuseanschluß. Diese Gehäuseanschlüsse führen aus einem das Substrat, die Halbleiterkörper, die Leiterbahnen und die Bonddrähte einhüllenden Gehäuse und sind zum Anschluß an externe Spannungsquellen bzw. eine externe Last bestimmt. Die Gehäuseanschlüsse 19, 20 liegen symmetrisch zur Symmetrieachse 24 auf den Brücken 15 bzw. 16 oder anders ausgedrückt auf den Jochen der U-förmigen Leitersysteme. Die Gehäuseanschlüsse 22, 23 sitzen in der Mitte der Längsausdehnung der dritten bzw. vierten Leiterbahn. Sitzen dazu die Halbleiterkörper 6 gleichmäßig verteilt auf den Leiterbahnen 2, 12, so erhält man weitgehend gleichmäßige Stromaufteilung und gleichmäßige Einschaltbedingungen für alle MOSFET.

Die Ausführungsbeispiele nach den Figuren 1 und 2 weisen jeweils sechs Halbleiterkörper auf. Es ist jedoch auch möglich, nach dem gleichen Prinzip Halbleiterbauelemente mit weniger oder mehr, vorzugsweise einer gradzahligen Anzahl von Halbleiterkörpern aufzubauen. Es ist auch möglich, Halbleiterbauelemente nach dem beschriebenen Prinzip aufzubauen, die beispielsweise nur eine einzige auf einer Seite der Symmetrieachse liegende Anordnung enthält. Außerdem ist denkbar, Halbleiterbauelemente mit nur einem einzigen Halbleiterkörper nach dem dargestellten Prinzip aufzubauen.

Abweichend von der in den Figuren 1 und 2 gezeigten Zuordnung der U-förmigen ersten und zweiten Leiterbahnen 2, 12; 3, 13 können diese auch nach Art von Fingerstrukturen miteinander verzahnt sein.

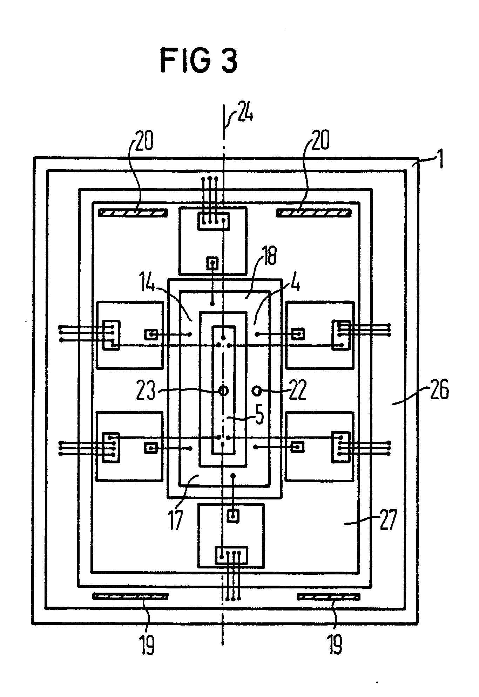

Ein weiteres Ausführungsbeispiel ist in Figur 3 gezeigt. Dort sind auch die ersten und die zweiten Leiterbahnen jeweils als geschlossene Ringe 26 bzw. 27 ausgebildet und ineinanderliegend angeordnet. Im Ring 27 liegen die ebenfalls einen Ring bildenden dritten Leiterbahnen 4, 14, 17, 18. Zwei der Halbleiterkörper liegen auf der Symmetrieachse 24. Die Gehäuseanschlüsse 19, 20 sind hier geteilt worden und kontaktieren die Ringe 26, 27 beidseitig dieser Halbleiterkörper. Sie liegen rechtwinklig und symmetrisch zur Symmetrieachse 24.

Für besonders hohe Anforderungen kann es zweckmäßig sein, zusätzlich in an sich bekannter Weise in den Gateanschluß jedes Halbleiterkörper einen Widerstand 25 (Figur 2) einzuschalten. Ein solcher Widerstand kann z. B. ein dotiertes Halbleiterplättchen sein, das jeweils auf die Leiterbahnen 4, 14 aufgelötet ist. Der Bonddraht 11 kontaktiert dann die Oberseite des Plättchens.

## Patentansprüche

1. Halbleiterbauelement mit mindestens einem Leistungs-MOSFET, dessen Halbleiterkörper einen Sourcekontakt und einen mit diesem verbundenen Sourceanschluß sowie einen Gatekontakt (7) und einen mit diesem verbundenen Gateanschluß hat,
gekennzeichnet durch ein elektrisch isolierendes, thermisch leitendes, mit Leiterbahnen versehenes Substrat (1), durch mehrere, auf einer ersten Leiterbahn (2) in einer Reihe hintereinander angeordnete Halbleiterkörper (6), durch eine zweite, auf der einen Längsseite der Reihe liegende Leiterbahn (3), die elektrisch mit den Sourcekontakten verbunden ist, durch eine dritte, auf der anderen Längsseite der Reihe liegende Leiterbahn (4), die mit den Gatekontakten (7) verbunden ist, und durch eine vierte, ebenfalls auf der anderen Längsseite der Reihe liegende Leiterbahn (5), die einen Hilfsanschluß bildet und mit den Sourcekontakten (8) verbunden ist.

2. Halbleiterbauelement nach Anspruch 1, **dadurch gekennzeichnet,** daß die dritte und vierte Leiterbahn (4, 5) nahe beieinander angeordnet sind und mindestes teilweise einander parallel liegen.

3. Halbleiterbauelement nach Anspruch 1 oder 2, **dadurch gekennzeichnet,** daß die Kontakte (7, 8) der Halbleiterkörper mit den zugeordneten Leiterbahnen über Bonddrähte (9, 10, 11) verbunden sind.

4. Halbleiterbauelement nach Anspruch 3, **dadurch gekennzeichnet,** daß die mit der dritten und vierten Leiterbahn (4, 5) verbundenen Bonddrähte (10, 11) nahe beieinander und parallel zueinander angeordnet sind.

5. Halbleiterbauelement nach Anspruch 3 oder 4, **dadurch gekennzeichnet,** daß sich die Bonddrähte (9, 10, 11) rechtwinklig zu den Leiterbahnen (2, 3, 4, 5) erstrecken.

6. Halbleiterbauelement nach einem der Ansprüche 1 bis 5, **gekennzeichnet** durch jeweils zwei spiegelsymmetrisch zueinander angeordnete erste, zweite und dritte Leiterbahnen (2, 12; 3, 13; 4, 14),
durch spiegelsymmetrisch auf den ersten Leiterbahnen angeordnete Halbleiterkörper (6),
durch eine in der Symmetrieachse (24) liegende vierte Leiterbahn (5) und
durch eine symmetrische elektrische Verbindung jeweils zwischen den ersten, zweiten und dritten Leiterbahnen der beiden Symmetriehälften.

7. Halbleiterbauelement nach Anspruch 6, **dadurch gekennzeichnet,** daß die ersten und zweiten Leiterbahnen (2, 12; 3, 13) zusammen mit jeweiligen Brücken (16,15) einen ersten und zweiten Leiter bilden, der jeweils U-förmig ausgebildet ist, daß diese Leiter um 180° gegeneinander gedreht ineinander verschachtelt angeordnet sind,

daß die dritte Leiterbahn (4, 14) ein geschlossener rechteckiger Ring ist und innerhalb des U-förmigen zweiten Leiters (3, 13) liegt und daß die vierte Leiterbahn (5) als Streifen ausgebildet ist und innerhalb des Rings liegt.

8. Halbleiterbauelement nach Anspruch 7, **dadurch gekennzeichnet,** daß die Leiterbahnen oder Leiter mit Gehäuseanschlüssen (19, 20, 22, 23) versehen sind, daß die Gehäuseanschlüsse (20, 19) für die ersten und zweiten Leiterbahnen (2,12;3,13) symmetrisch zur Symmetrieachse (24) auf den Brücken 15,16 der U-förmigen ersten und zweiten Leiter sitzen und daß die Gehäuseanschlüsse (22, 23) für die dritte und vierte Leiterbahn (4, 14; 5) wenigstens annähernd in der Mitte von deren Längsausdehnung liegen.

9. Halbleiterbauelement nach einem der Ansprüche 1 bis 8, **dadurch gekennzeichnet,** daß in den Gateanschluß ein Widerstand (25) geschaltet ist.

10. Halbleiterbauelement nach Anspruch 6, **dadurch gekennzeichnet,** daß die erste, zweite und dritte Leiterbahn jeweils als geschlossener Ring (26; 27; 4, 14, 17, 18) ausgebildet ist wobei diese Ringe ineinander angeordnet sind, und daß die vierte Leiterbahn (5) streifenförmig innerhalb des innersten Rings liegt.

11. Halbleiterbauelement nach Anspruch 10, **dadurch gekennzeichnet,** daß die Leiterbahnen mit Gehäuseanschlüssen (19, 20, 22, 23) versehen sind, daß die Gehäuseanschlüsse (19, 20) für die erste und zweite Leiterbahn senkrecht und symmetrisch zur Symmmetrieachse (24) liegen, und daß die Gehäuseanschlüsse (22, 23) für die dritte und vierte Leiterbahn (4, 14; 5) wenigstens annähernd in der Mitte von deren Längsausdehnung liegen.

**Claims**

1. Semiconductor component having at least one power MOSFET whose semiconductor body has a source contact and a source terminal connected thereto as well as a gate contact (7) and a gate terminal connected thereto, characterised by an electrically insulating, thermally conducting substrate (1) provided with printed conductors, by a plurality of semiconductor bodies (6) arranged behind one another in a row on a first printed conductor (2), by a second printed conductor (3), which is situated on one longitudinal side of the row and is connected electrically to the source contacts, by a third printed conductor (4), which is situated on the other longitudinal side of the row and is connected to the gate contacts (7), and by a fourth printed conductor (5), which is likewise situated on the other longitudinal side of the row, forms an auxiliary terminal, and is connected to the source contacts (8).

2. Semiconductor component according to Claim 1, characterised in that the third and fourth printed conductor (4, 5) are arranged close to one another and are situated at least partially parallel to one another.

3. Semiconductor component according to Claim 1 or 2, characterised in that the contacts (7, 8) of the semiconductor bodies are connected to the assigned printed conductors via bonding wires (9, 10, 11).

4. Semiconductor component according to Claim 3, characterised in that the bonding wires (10, 11) connected to the third and fourth printed conductor (4, 5) are arranged close to one another and parallel to one another.

5. Semiconductor component according to Claim 3 or 4, characterised in that the bonding wires (9, 10, 11) extend at right angles to the printed conductors (2, 3, 4, 5).

6. Semiconductor component according to one of Claims 1 to 5, characterised by in each case two first, second and third printed conductors (2, 12; 3, 13; 4, 14) arranged with mirror symmetry with respect to one another, by semiconductor bodies (6) arranged with mirror symmetry on the first printed conductors, by a fourth printed conductor (5) situated on the axis of symmetry (24), and by a symmetrical electrical connection between in each case the first, second and third printed conductors of the two symmetrical halves.

7. Semiconductor component according to Claim 6, characterised in that, together with respective bridges (16, 15), the first and second printed conductors (2, 12; 3, 13) form a first and second conductor which is constructed in each case in a U-shaped fashion, in that these conductors are arranged, rotated by 180° with respect to one another, interleaved in one another, in that the third printed conductor (4, 14) is a closed rectangular ring and is situated inside the U-shaped second conductor (3, 13), and in that the fourth printed conductor (5) is constructed as a strip and situated inside the ring.

8. Semiconductor component according to Claim 7, characterised in that the printed conductors or conductors are provided with package terminals (19, 20, 22, 23), in that the package terminals (20, 19) for the first and second printed conductors (2, 12; 3, 13) are seated symmetrically with respect to the axis of symmetry (24) on the bridges (15, 16) of the U-shaped first and second conductors, and in that the package terminals (22, 23) for the third and fourth printed conductor (4, 14; 5) are situated at least approximately in the middle of their longitudinal extent.

9. Semiconductor component according to one of Claims 1 to 8, characterised in that a resistor (25) is connected in the gate terminal.

10. Semiconductor component according to Claim 6, characterised in that the first, second and third printed conductor is constructed in each case as a closed ring (26; 27; 4, 14, 17, 18), these rings be arranged inside one another, and in that the fourth printed conductor (5) is situated in the shape of a strip inside the innermost ring.

11. Semiconductor component according to Claim 10, characterised in that the printed conductors are provided with package terminals (19, 20, 22, 23), in that the package terminals (19, 20) for the first and second printed conductor are situated perpendicularly and symmetrically with respect to the axis of symmetry (24), and in that the package terminals (22, 23) for the third and fourth printed conductor (4, 14; 5) are situated at least approximately in the middle of their longitudinal extent.

**Revendications**

1. Composant à semiconducteurs comportant au moins un transistor MOSFET de puissance, dont le corps semiconducteur possède un contact de source et une borne de source raccordée à ce contact, ainsi qu'un contact de grille (7) et une borne de grille raccordée à ce contact, caractérisé par un substrat électriquement isolant et thermiquement conducteur (1), comportant des voies conductrices, par plusieurs corps semiconducteurs (6) disposés en rangée les uns derrière les autres sur une première voie conductrice (2), par une seconde voie conductrice (3) disposée sur un côté longitudinal de la rangée et raccordée électriquement aux contacts de source, par une troisième voie conductrice (4) disposée sur l'autre côté longitudinal de la rangée et raccordée aux contacts de grille (7), et par une quatrième voie conductrice (5) également située sur l'autre côté longitudinal de la rangée et formant une borne auxiliaire et raccordée aux contacts de source (8).

2. Composant à semiconducteurs suivant la revendication 1, caractérisé par le fait que les troisième et quatrième voies conductrices (4,5) sont disposées à proximité l'une de l'autre et sont situées au moins partiellement en parallèle.

3. Composant à semiconducteurs suivant la revendication 1 ou 2, caractérisé par le fait que les contacts (7,8) des corps semiconducteurs sont raccordés aux voies conductrices associées par l'intermédiaire de fils de liaison (9,10,11).

4. Composant à semiconducteurs suivant la revendication 3, caractérisé par le fait que les fils de liaison (10,11) raccordés aux troisième et quatrième voies conductrices (4,5) sont disposés à proximité l'un de l'autre en parallèle entre eux.

5. Composant à semiconducteurs suivant la revendication 3 ou 4, caractérisé par le fait que les fils de liaison (9,10,11) s'étendent perpendiculairement aux voies conductrices (2,3,4,5).

6. Composant à semiconducteurs suivant l'une des revendications 1 à 5, caractérisé par respectivement deux premières, secondes et troisièmes voies conductrices respectives (2,12; 3,13; 4,14) disposées symétriquement,
par des corps semiconducteurs (6) disposés symétriquement sur les premières voies conductrices,
par une quatrième voie conductrice (5) située sur l'axe de symétrie (24), et
par une liaison électrique symétrique établie respectivement entre les premières, secondes et troisièmes voies conductrices des deux moitiés symétriques.

7. Composant à semiconducteurs suivant la revendication 6, caractérisé par le fait que les premières et secondes voies conductrices (2,12; 3,13) forment, conjointement avec des ponts respectifs (16,15), des premier et second conducteurs qui sont réalisés respectivement en forme de U,
que ces conducteurs sont disposés en étant imbriqués l'un dans l'autre et décalés réciproquement de 180°,

que la troisième voie conductrice (4,14) est un anneau rectangulaire fermé et est située à l'intérieur du second conducteur (3,13) en forme de U et que la quatrième voie conductrice (5) est réalisée sous la forme d'une bande et est située à l'intérieur de l'anneau.

8. Composant à semiconducteurs suivant la revendication 7, caractérisé par le fait que les voies conductrices ou conducteurs sont équipés de bornes de boîtier (19,20,22,23), que les bornes de boîtier (20,19) pour les premières et secondes voies conductrices (2,12; 3,13) sont disposées, symétriquement par rapport au plan de symétrie (24), sur les premier et second conducteurs en forme de U, et que les bornes de boîtier (22,23) pour les troisième et quatrième voies conductrices (4,14; 5) sont situées au moins approximativement au centre de l'étendue longitudinale de ces voies conductrices.

9. Composant à semiconducteurs suivant l'une des revendications 1 à 8, caractérisé par le fait qu'une résistance (25) est branchée dans la borne de grille.

10. Composant à semiconducteurs suivant la revendication 6, caractérisé par le fait que les première, seconde et troisième voies conductrices sont réalisées respectivement sous la forme d'anneaux fermés (26; 27; 4; 14,17,18), qui sont disposés les uns dans les autres, et que la quatrième voie conductrice (5) est disposée sous la forme d'une bande à l'intérieur de l'anneau le plus intérieur.

11. Composant à semiconducteurs suivant la revendication 10, caractérisé par le fait que les voies conductrices comportent des bornes de boîtier (19,20,22,23), que les bornes de boîtier (19,20) pour les première et seconde voies conductrices sont perpendiculaires à l'axe de symétrie (24) et symétriques par rapport à cet axe, et que les bornes de boîtier (22,23) pour les troisième et quatrième voies conductrices (4,14; 5) sont situées au moins approximativement au centre de l'étendue longitudinale des voies conductrices.

FIG 1

FIG 2

7

# FIG 3